# EUROPEAN PATENT APPLICATION

(11) **EP 2 296 179 A2**
(43) Date of publication of application: **16.03.2011**
(21) Application number: 10175632.8
(22) Date of filing: 07.09.2010
(51) Int. Cl.: H01L 25/075, H01L 33/50

(54) **Illumination device**

(30) Priority: 09.09.2009 JP 2009208431
(71) Applicant: Panasonic Electric Works Co., Ltd, Kadoma-shi Osaka 571-8686 (JP)
(72) Inventor: Imamura, Hiroshi, Osaka (JP); Yokotani, Ryoji, Osaka (JP)
(74) Representative: Rüger, Barthelt & Abel Patentanwälte

(57) **Abstract**

[Object] To provide an illumination device with little color unevenness and a high luminous efficiency.

[Means for Settlement] On a mounting substrate 10, a plurality of LED chips 20 are mounted separately from each other, and a fluorescent body part 30 is disposed at a periphery of the LED chips 20 and at a space portion between the LED chips 20. Then at a region of this fluorescent body part 30 covering the space between the LED chips 20, a groove part 41 is provided. Consequently, a light path length of light radiated from the LED chip 20 until it is radiated to outside of the fluorescent body part 30 become substantially equal without depending on a light radiation direction.

Therefore, a ratio of light converted into light of a different color by the fluorescent body part 30 and non-converted light becomes substantially uniform without depending on a place, which can therefore suppress color unevenness. Moreover, the periphery of the LED chip 20 is covered by the fluorescent body part 30 without any space therebetween, so that light radiated from a side surface of the LED chip 20 also contributes to light emission by being converted into light of a different color by a fluorescent body or otherwise. Therefore, the high luminous efficiency can be provided.

## Description

### [Field of the Invention]

The present invention relates to an illumination device using a plurality of light-emitting diode chips.

### [Background Art]

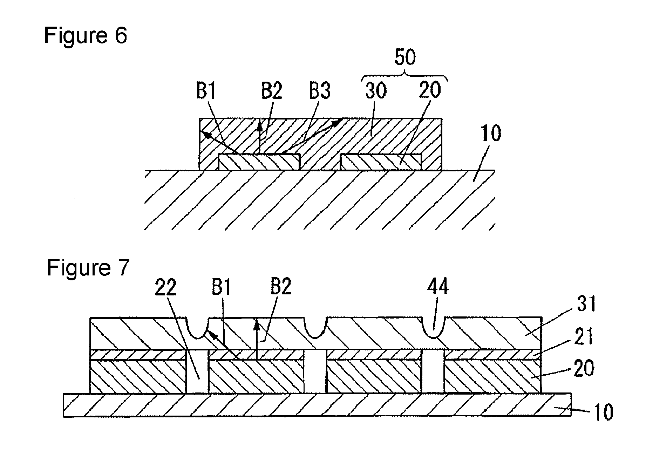

Conventionally, an illumination device as shown in Fig. 6 has been provided which has a plurality of light-emitting diode (hereinafter indicated as LED) chips 20 mounted on a mounting substrate 10 for better luminous intensity and also covered without any space by a fluorescent body part 30 formed of a translucent material containing a fluorescent body. In particular, the one which uses a blue LED as an LED and which uses as the fluorescent body a fluorescent body converting blue light radiated from the blue LED into yellow light is useful as a white light source.

However, in the conventional example described above, the fluorescent body part 30 is formed in a manner such that a thickness of a light-emitting part 50 including the LED chips 20 and the fluorescent body part 30 becomes uniform without depending on a place, thus causing color unevenness. Specifically, comparison of light path lengths of blue light B1 to B3 (see Fig. 6) radiated from the blue LED chip 20 until it is radiated to outside of the fluorescent body part 30 shows that the light path length of B1 or B3 radiated laterally of the LED chip 20 is long while the light path length of B2 radiated outwardly in the figure is short. Here, a proportion of light radiated from the LED chip 20 and then converted into yellow light depends on a light path length of this light until it is radiated to the outside of the fluorescent body part 30. Therefore, for light radiated from immediately above the LED chip 20, the proportion of the converted light is small and thus a ratio of blue light is large; for light radiated from a peripheral edge portion of the fluorescent body part 30 or a space portion between the LED chips 20, the proportion of the converted light is large and thus a ratio of yellow light is large, thus causing a color difference (color unevenness) depending on a place.

As a method of solving this problem, Patent Document 1 describes an illumination device having a florescent body sheet 31 which is disposed on top surfaces of a plurality of LED chips 20 mounted with a space therebetween and which has groove parts 44 each formed at a region covering the space between the LED chips 20 (see Fig. 7, where 21 is an adhesive agent). In this conventional example, a light path length of light (B1) radiated from the top surface of the LED chip 20 toward the groove part 44 until it is radiated to outside of the fluorescent body sheet 31 is shorter than that of the conventional example described above, and is substantially equal to a light path length of light (B2) radiated from the top surface of the LED chip 20 outwardly of the LED chip 20 until it is radiated to the outside of the fluorescent body sheet 31. Thus, a ratio of blue light and yellow light becomes substantially uniform without depending on a place on a surface of the fluorescent body sheet 31, which can therefore suppress occurrence of color unevenness.

### [Conventional technique document]

[Patent Document 1] Japanese Unexamined Patent Publication No. 2008-294224
[Disclosure of the Invention]
[Problems to be solved by the Invention]

However, in the conventional example described in Patent Document 1, the top surfaces of the LED chips 20 are covered by the sheet-like fluorescent body sheet 31, thus forming an air layer 22 between the LED chips 20. Thus, there arises a risk that a part of light emitted from a side surface of the LED chip 20 is lost as a result of being subjected to multiple reflection between side surfaces of the LED chips 20 or otherwise, resulting in a deteriorated luminous efficiency.

In view of the problem described above, the present invention has been made, and it is an object of the present invention to provide an illumination device with little color unevenness and a high luminous efficiency.

### [Means adapted to solve the Problems]

To achieve the object described above, a first aspect of the present invention includes: a mounting substrate; a plurality of light-emitting diode chips mounted on the mounting substrate separately from each other; and a fluorescent body part formed of a translucent material containing a fluorescent body converting light radiated from the light-emitting diode chip into light of a color different from a color of the radiated light, wherein: the fluorescent body part covers all surfaces of the light-emitting diode chip, excluding a surface mounted on the mounting substrate, with no space provided between the fluorescent body part and the light-emitting diode chip, and is also formed to cover a space between the light-emitting diode chips with no space provided between the fluorescent body part and the mounting substrate; and on a surface of the fluorescent body part covering the space, a groove part is provided along end surfaces of the light-emitting diode chips forming the space.

In the first aspect of the present invention, the groove part is provided at a region of the fluorescent body part covering the space between the light-emitting diode chips; therefore, a light path length of light emitted from the light-emitting diode chip until it is radiated to outside of the fluorescent body part become substantially equal without depending on a light radiation direction. Therefore, a ratio of light converted into light of a different color and non-converted light becomes substantially uniform without depending on a place, which can therefore suppress occurrence of color unevenness. Moreover, a periphery of the plurality of light-emitting diode chips is covered by the fluorescent body part without any space therebetween; therefore, light radiated from a side surface of this light-emitting diode chip is radiated to the outside by being converted into light of a different color by the fluorescent body located at the space portion between the light-emitting diode chips or otherwise, which contributes to light emission. Thus, a luminous efficiency can be improved more than by the conventional example described in Patent Document 1.

A second aspect of the present invention refers to the illumination device of the first aspect, wherein a distance between a deepest part of the groove part and the mounting substrate is made closer than a distance between the mounting substrate and one of the surfaces of the light-emitting diode chip most distant from the mounting substrate.

In the second aspect of the present invention, a depth of the groove part formed at the fluorescent body part is deeper than a thickness of the fluorescent body part at the region covering the light-emitting diode chips; therefore, the deepest part of the groove part is consequently located on a side of the LED chip. Thus, also for light laterally radiated from the side surface of the light-emitting diode chip, the light path length thereof until it is radiated to the outside of the fluorescent body part can be controlled, which can provide greater color unevenness suppressing effect than that provided in a case where the depth of the groove part is small.

A third aspect of the present invention refers to the illumination device of the first or second aspect, wherein the fluorescent body part is formed into such a sectional shape that is substantially equal to light distribution of light exiting from the light-emitting diode chip.

In the third aspect of the present invention, the fluorescent body part is formed into such a sectional shape that is substantially equal to light distribution of light exiting from the light-emitting diode chip, whereby the ratio of the light converted into light of a different color by the fluorescent body part and the non-converted light becomes uniform without depending on a place. Thus, the color unevenness can be more reliably suppressed.

### [Effect of the Invention]

The present invention can provide an illumination device with little color unevenness and a high luminous efficiency.

### [Brief Description of the Drawings]

[Fig.1] Fig.1 is a sectional view of vicinity of an LED chip 20 of a first embodiment.
[Fig.2] Fig.2 is a perspective view of the first embodiment.
[Figs. 3] Figs. 3 (a), (b), (c), and (d) are diagrams showing procedures of forming a fluorescent body part 30 by a cutting method in the first embodiment.
[Figs. 4] Fig. 4 (a) is a perspective view of a second embodiment and Fig. 4 (b) is a sectional view of vicinity of an LED chip 20 of the second embodiment.
[Fig. 5] Fig. 5 is a sectional view of vicinity of an LED chip 20 of a third embodiment.
[Fig. 6] Fig. 6 is a sectional view of a conventional example.
[Fig. 7] Fig. 7 is a sectional view of another conventional example.

### [Best Mode for Carrying Out the Invention]

### (First Embodiment)

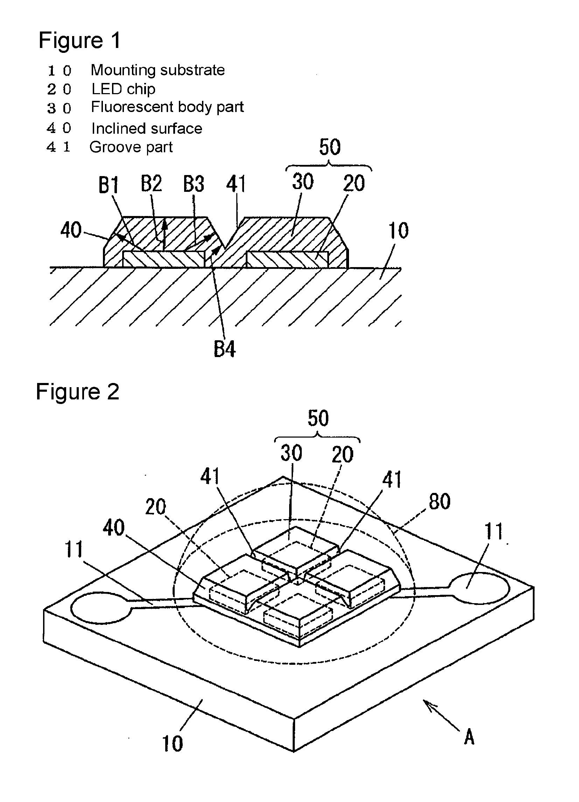

The first embodiment of the present invention will be described referring to Figs. 1 to 3. In the following description, top to bottom in Fig. 1 is defined as a vertical direction.

An illumination device A of the present embodiment includes: as shown in Fig. 2, a mounting substrate 10 of a flat shape; a plurality of (four in the figure) LED chips 20 mounted, with a space therebetween, on a top surface side of the mounting substrate 10; a fluorescent body part 30 which includes a fluorescent body excited by light radiated from each of the LED chips 20 to radiate light of a color different from that of the aforementioned light and which is arranged in such a form as to cover all the LED chips 20 on the top surface side of the mounting substrate 10; and a transparent lens 80 (indicated by a broken line in the figure) of a dome-like shape arranged in such a form as to cover the fluorescent body part 30 on the top surface side of the mounting substrate 10. That is, the illumination device A of the present embodiment forms a light emission part 50 with the plurality of LED chips 20 and one fluorescent body part 30.

The mounting substrate 10 is formed of a high heat radiating material, such as copper, aluminum, or the like with, for example, a submounted alumina substrate or aluminum nitride, and is formed into a flat shape. Then on the top surface side thereof, a wiring pattern 11 (only part of the wiring pattern 11 is shown in Fig. 2) is formed.

The LED chips 20 are blue LED chips of, for example, a GaN group each of which is of a substantially rectangular solid shape and radiates blue light from a top surface and a side surface thereof, and are arranged on the mounting substrate 10 with a space therebetween. Then although not shown, by a packaging means adapted to perform, for example, wire bonding after flip chip mounting or die bonding, the LED chips 20 are mounted on the mounting substrate 10 while electrically connected to the wiring pattern 11.

The fluorescent body part 30, as shown in Fig. 1, is disposed in such a manner as to cover each of the LED chips 20 without any space provided between the fluorescent body 30 and this LED chip 20, and the fluorescent body part 30 has inclined surfaces 40 of a planar shape each formed on a side surface thereof and groove parts 41 of a substantially V-shape each formed at a region covering the space between the LED chips 20. Disposing the plurality of LED chips 20 on the mounting substrate 10 forms a space between a side end surface of one LED chip 20 and a side end surface of another LED chip 20 along these side end surfaces, and the groove part 41 is provided along the side end surfaces of the LED chips 20 forming this space.

This fluorescent body part 30 is formed by evenly dispersing to thermal cured silicon resin a granulous yellow fluorescent body excited by the blue light radiated from the LED chip 20 to radiate yellowish light. Therefore, the illumination device A of the present embodiment radiates from a surface of the fluorescent body part 30 the blue light radiated from the LED chip 20 and the yellow light obtained by conversion by the yellow fluorescent body, whereby white light can be provided

Here, an example of a method of forming the fluorescent body part 30 will be described briefly.

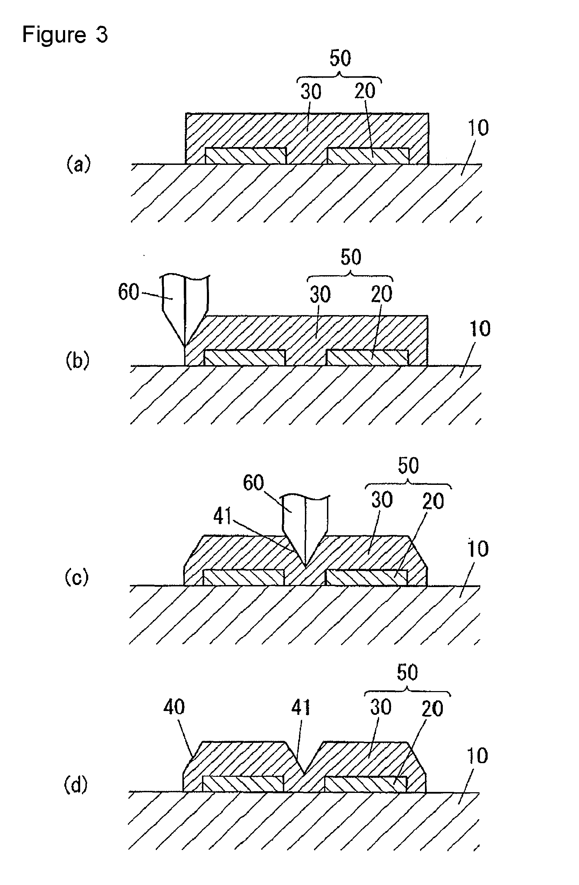

First, the fluorescent body part 30 is, by a molding method or a screen printing method (the molding method and the screen printing method are well known and thus are omitted from the description), formed into a substantially rectangular solid shape while covering the plurality of LED chips 20 mounted on the mounting substrate 10 (Fig. 3(a)).

Next, by using a rotational cutting blade 60, an inclined surface 40 is formed on the side surface of the fluorescent body part 30 (Fig. 3(b)). Here, the inclined surface 40 is shown only cross-sectionally in Fig. 3, but is actually formed along the side surface of the fluorescent body part 30 as shown in Fig. 2.

Similarly, by using the rotational cutting blade 60, the groove part 41 is formed into a V shape at a region of the fluorescent body part 30 covering the space between the LED chips 20 (Fig. 3(c)).

The inclined surface 40 is formed along all side surfaces of the fluorescent body part 30, and the groove part 41 is formed at each space between the plurality of LED chips 20. Moreover, for order of forming the inclined surfaces 40 and the groove parts 41, either of them can come first.

Through the procedures described above, the fluorescent body part 30 provided with the inclined surfaces 40 and the groove parts 41 is formed (Fig. 3(d)).

The procedures of forming the inclined surfaces 40 and the groove parts 41 by a cutting method has been described above, but the fluorescent body part 30 of a shape of Fig. 2 may be formed at once by a molding method with a mold of a shape that permits the formation of the inclined surfaces 40 and the groove parts 41.

The transparent lens 80 improves efficiency of light extraction from the fluorescent body part 30, and is formed of, for example, translucent thermal cured silicon resin formed into a dome-like shape, which is then disposed in such a manner as to cover the entire fluorescent body part 30 on the top surface side of the mounting substrate 10. Note that a material of the transparent lens 80 is not limited to the silicon resin, and thus may be, for example, epoxy resin, glass, or the like.

In the illumination device A of the present embodiment, by forming the inclined surfaces 40 and the groove parts 41 at the fluorescent body part 30, as shown in Fig. 1, a light path length of light radiated from the LED chip 20 (denoted by arrows B1 to B4) until it is radiated to outside of the fluorescent body part 30 are substantially uniform without depending on a light exit direction. Thus, a proportion of the blue light to be converted into yellow light becomes substantially uniform without depending on the light exit direction; therefore, a ratio between the blue light and the yellow light becomes substantially uniform without depending on a place on the surface of the fluorescent body part 30, which can suppress color unevenness. Moreover, since the fluorescent body part 30 is also disposed at a space portion between the LED chips 20, the light (B4) radiated from the side surface of the LED chip 20 is also radiated to the outside by being converted into yellow light by the fluorescent body in the fluorescent body part 30 disposed at the space portion, dispersed, or otherwise. That is, this light also contributes to light emission, thus permitting an improvement in the luminous efficiency.

Described in the present embodiment is the illumination device A provided with the four LED chips 20, but the number of LED chips 20 is not limited to four but may be any number equal to or larger than 2. Moreover, the fluorescent body in the fluorescent body part 30 is not limited to the yellow fluorescent body but a plurality of kinds of fluorescent bodies may be used for the purpose of color adjustment, improving a color rendering property, or the like. For example, a red fluorescent body and a green fluorescent body can be used to provide white light with a high color rendering property. Moreover, the LED chip 20 is not limited to the blue LED chip and thus, for example, an LED chip radiating ultraviolet light may be provided and a blue fluorescent body and a yellow fluorescent body may be contained in the fluorescent body part 30 to thereby provide white light from the light emission part 50. Furthermore, the white color is illustrated as a color of light emitted from the light emission part 50 in the present embodiment, but the color of the light emitted from the light emission part 50 is not limited to whitish color. In this case, a red LED chip, a green LED chip, or the like may be used as the LED chip 20. Moreover, the shape of the inclined surface 40 is not limited to the planar shape and thus may be a curved shape or the like, and the shape of the groove part 41 is also not limited to the V shape and thus may be a U shape or the like.

### (Second Embodiment)

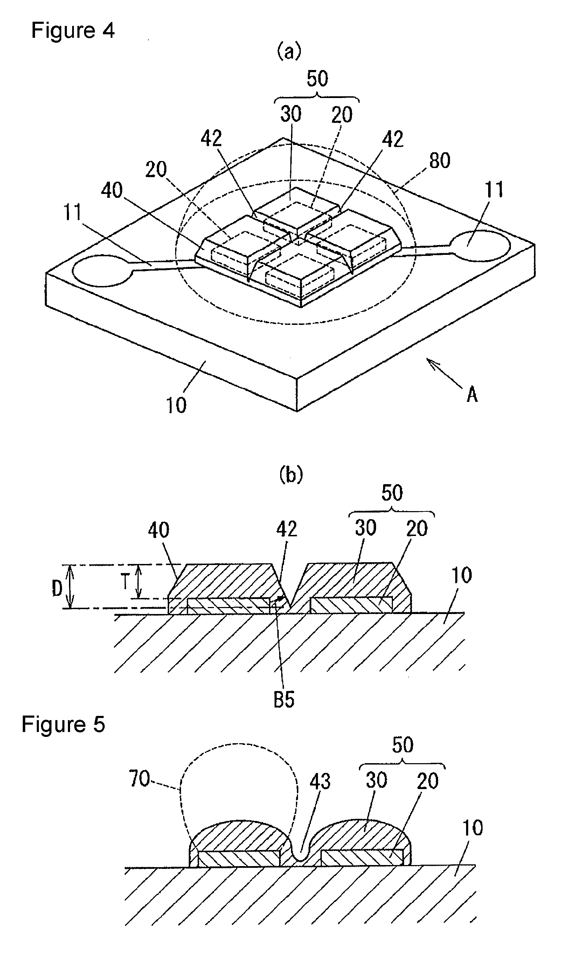

A second embodiment of the present invention will be described referring to Fig. 4. The present embodiment has a same configuration as that of the first embodiment except for a point that a depth D of a groove part 42 is formed deeper than a thickness T of a fluorescent body part 30 above LED chips 20, and thus common components are provided with the same numerals and omitted from the description.

From the LED chip 20, light is radiated from not only a top surface thereof but also a side surface thereof. In the present embodiment, the depth D of the groove part 42 is formed deeper than the thickness T of the fluorescent body part 30 disposed on the top surface of the LED chip 20. This permits control of a light path length of light radiated laterally from the side surface of the LED chip 20 until it is radiated to outside of the fluorescent body part 30, thus permitting appropriate control of a proportion of this light converted into yellow light in the fluorescent body part 30. Therefore, a greater color unevenness suppressing effect can be provided than that provided in a case where the depth D of the groove part 42 is smaller than the thickness T of the fluorescent body part 30 disposed on the top surface of the LED chip 20.

### (Third Embodiment)

A third embodiment of the present invention will be described referring to Fig. 5. The present embodiment has a same configuration as that of the first or second embodiment described above except for a point that a fluorescent body part 30 is formed into such a sectional shape that is substantially equal to light distribution 70 of an LED chip 20, and thus common components are provided with the same numerals and thus omitted from the description.

The light distribution 70 of the LED chip 20 is strong around a center of the LED chip 20 and becomes increasingly weaker toward the side thereof, and is expressed by a curved surface as shown by a broken like of Fig. 5. In the present embodiment, a thickness of the fluorescent body part 30 is changed in accordance with this light distribution 70. As a result of forming the fluorescent body part 30 in such a manner, at a region where intensity of blue light radiated from the LED chip 20 is strong, the thickness of the fluorescent body part 30 is large, and also intensity of light converted into yellow light at the fluorescent body part 30 is strong. On the contrary, at a region where the intensity of the blue light radiated from the LED chip 20 is weak, the thickness of the fluorescent body part 30 is small, and thus the intensity of the light converted into yellow light at the fluorescent body part 30 is also weak. Consequently, a ratio of the yellow light obtained by the conversion at the fluorescent body part 30 and the non-converted blue light becomes uniform without depending on a place on a surface of the fluorescent body part 30, which can practically eliminate color unevenness.

This fluorescent body part 30 is fabricated by, for example, a molding method by use of a mold of a desired shape.

### [Description of Reference Numerals]

- 10: Mounting substrate
- 20: LED chip
- 30: Fluorescent body
- 40: Inclined surface
- 41: Groove part

## Claims

1. An illumination device comprising:
a mounting substrate;
a plurality of light-emitting diode chips mounted on the mounting substrate separately from each other; and
a fluorescent body part formed of a translucent material containing a fluorescent body converting light radiated from the light-emitting diode chip into light of a color different from a color of the radiated light, wherein:
the fluorescent body part covers all surfaces of the light-emitting diode chip, excluding a surface mounted on the mounting substrate, with no space provided between the fluorescent body part and the light-emitting diode chip, and is also formed to cover a space between the light-emitting diode chips with no space provided between the fluorescent body part and the mounting substrate; and
on a surface of the fluorescent body part covering the space, a groove part is provided along end surfaces of the light-emitting diode chips forming the space.

2. The illumination device according to claim 1, wherein
a distance between a deepest part of the groove part and the mounting substrate is made closer than a distance between the mounting substrate and one of the surfaces of the light-emitting diode chip most distant from the mounting substrate.

3. The illumination device according to either of claims 1 and 2, wherein
the fluorescent body part is formed into such a sectional shape that is substantially equal to light distribution of light exiting from the light-emitting diode chip.
